# EUROPEAN PATENT SPECIFICATION

(11) **EP 1 096 553 B1**
(45) Date of publication and mention of the grant of the patent: **29.12.2010**
(21) Application number: 99925400.6
(22) Date of filing: 22.06.1999
(51) Int. Cl.: H01L 21/306

(54) **ANISOTROPIC ETCHING METHOD**
VERFAHREN ZUR ANISOTROPEN CHEMISCHEN ÄTZUNG
PROCEDE D'ATTAQUE CHIMIQUE ANISOTROPE

(30) Priority: 25.06.1998 JP 17863098; 25.06.1998 JP 17863198
(43) Date of publication of application: 02.05.2001
(73) Proprietor: Mitsubishi Materials Silicon Corporation, Chiyoda-ku, Tokyo (JP)
(72) Inventor: OI, Hiroyuki Mitsubishi Materials Silicon Corp., Tokyo 100-0005 (JP)
(74) Representative: HOFFMANN EITLE
(86) International application number: PCT/JP1999/003298
(87) International publication number: WO 1999/067814

(56) References cited:
- JP-A- 05 198 555
- JP-A- 09 266 193
- JP-A- 10 151 403
- JP-U- 05 066 714
- US-A- 5 511 569

## Description

### TECHNICAL FIELD

The present invention relates to an anisotropic etching method.

### BACKGROUND ART

The dielectric separative wafer is known as a kind of semiconductor wafer. In order to form a dielectric separative wafer, (i) grooves (for dielectric separation) are formed on the surface of a silicon wafer, (ii) an oxide film (i.e., insulating film) is formed on the wafer, (iii) a polysilicon is deposited on the insulating film by using the high-temperature CVD method, by a thickness approximately corresponding to the thickness of the wafer, and (iv) the silicon wafer side is ground and polished, so that isolated silicon single crystals, which are isolated from each other via the insulating film, are formed on the silicon wafer.

An anisotropic etching vessel, into which an etchant for anisotropic etching is injected, is used in a process of forming grooves (for dielectric separation) on a surface of the dielectric separative wafer. Here, in the anisotropic etching, the etching speed differs for each direction, that is, the etching speed measured in the depth direction is higher than the etching speed measured in the horizontal direction according to the direction of the crystal plane of the silicon wafer.

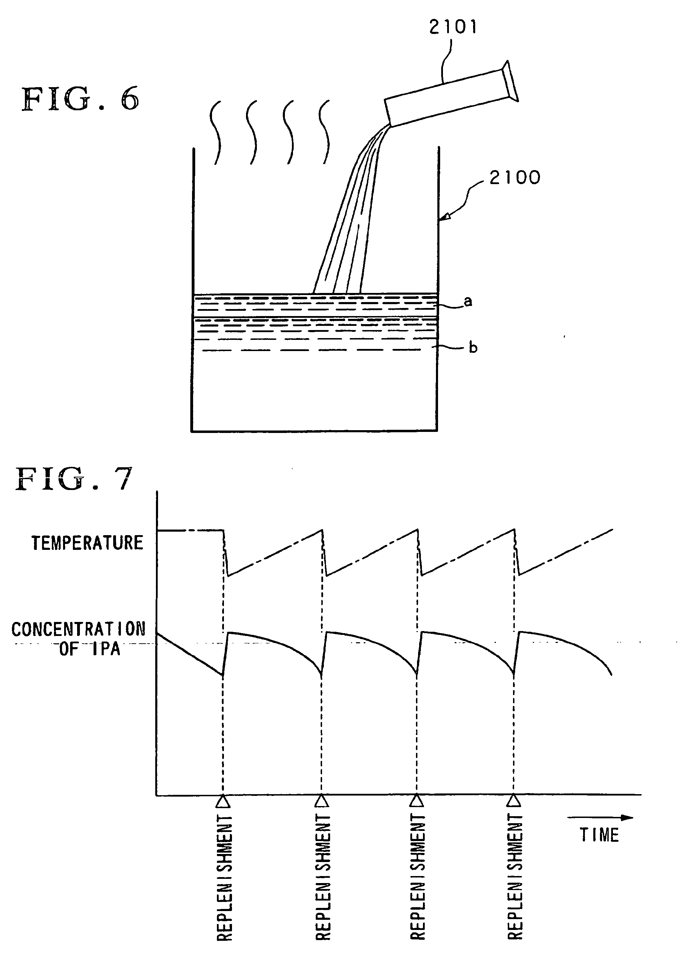

As a general anisotropic etchant, a three component etchant including IPA (isopropyl alcohol) / KOH (potassium hydroxide) / H₂O is known. Fig. 6 is a diagram for explaining the conventional process of replenishing the vessel with IPA. As shown in the figure, the anisotropic etchant in an anisotropic etching vessel 2100 is separated into two portions, that is, an upper IPA-rich portion "a" and a lower KOH-rich portion "b" according to the specific gravity of each portion.

Generally, the etching temperature of the anisotropic etching is 75 to 81 °C. This temperature range is close to the vaporization temperature of IPA (boiling point: 82.4 °C), where IPA has a relatively high volatility. In addition, the top of the anisotropic etching vessel 2100 is open; thus, the evaporating IPA diffuses to the outside from the top. As a result, the concentration of IPA in the anisotropic etchant is lowered, and the composition of the anisotropic etchant is changed. Accordingly, there occurs a problem in that the etching characteristics differ for each wafer case which contains a plurality of silicon wafers. If the composition of the anisotropic etchant changes by only ±1% by weight, the etching characteristics thereof considerably change.

Therefore, conventionally, an operator directly replenishes the vessel with an IPA replenishing liquid by a quantity corresponding to the evaporated IPA, by using a measuring cylinder 2101.

However, the temperature of IPA is generally room temperature in the replenishment. Therefore, as shown in the graph of Fig. 7 which shows the relationship between the replenishment timing and variations in the etching state, the temperature of the anisotropic etchant decreases every time the vessel is replenished, so that stable anisotropic etching cannot be performed.

Also in the time for awaiting the next replenishment of IPA, the composition of the anisotropic etchant gradually changes. As explained above, if the composition of the anisotropic etchant changes by only ±1% by weight, or if the temperature changes by only ±1 °C, the etching characteristics thereof considerably change.

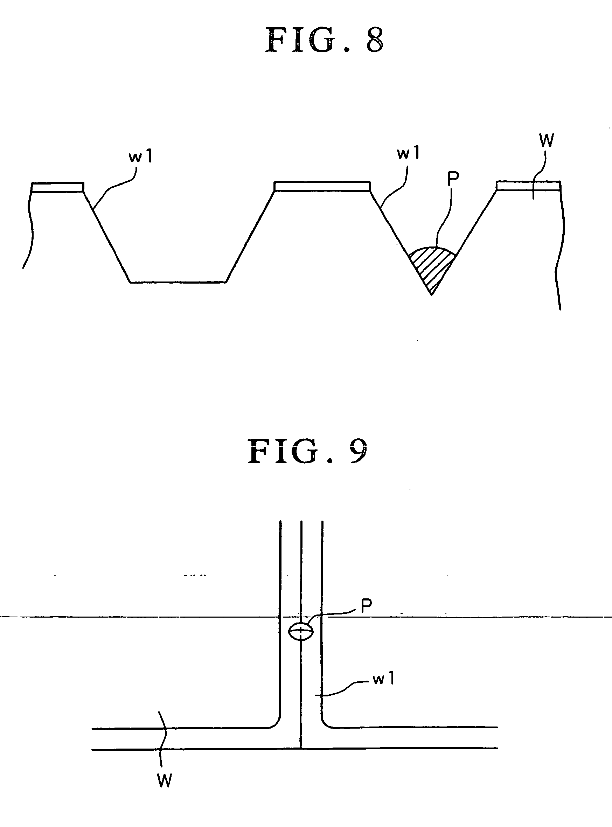

Figs. 8 and 9 are a partially-enlarged sectional view and a partially-enlarged plan of a surface of an anisotropically etched semiconductor wafer. According to the above-explained change of the etching characteristics, µ (micro) pyramids P may be generated on the etching surface of the silicon wafer W. Here, each µ pyramid forms a higher-order face in an anisotropic etching groove w1 which is formed in the etched surface, that is, the µ pyramid is a flaw in the surface, which has dependency on the crystal orientation.

Another problem also occurs in the conventional technique, in that the etching depth may not be uniform.

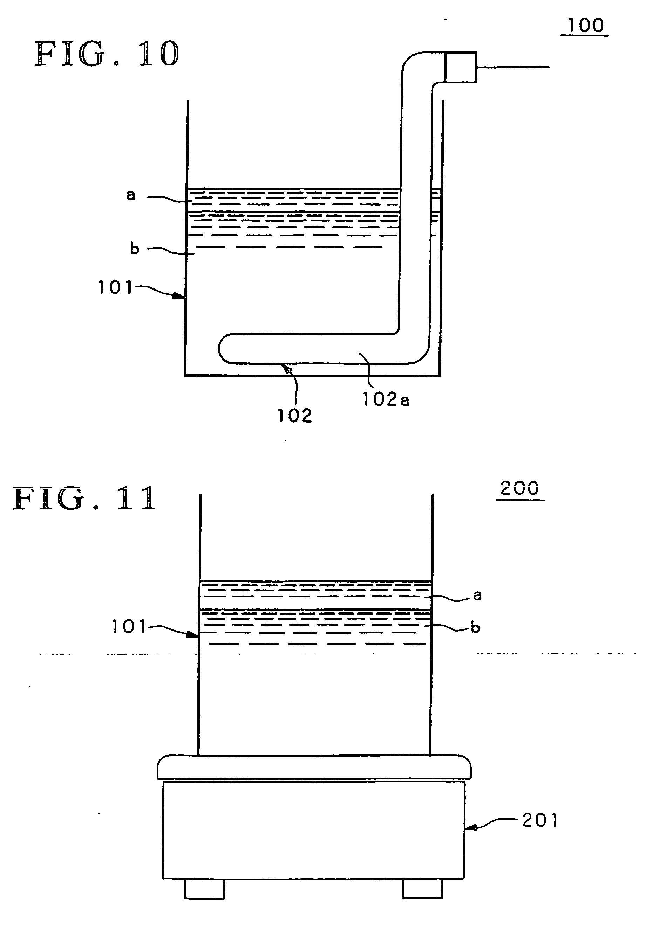

Below, with reference to Figs. 10 to 12, examples of the conventional anisotropic etching apparatuses will be explained. Figs. 10 to 12 respectively explain different conventional anisotropic etching apparatuses.

In the anisotropic etching apparatus 100 as shown in Fig. 10, a quartz heater 102 is put into an anisotropic etching vessel 101 whose top is open, and the anisotropic etchant is directly heated by the heat generated by the quartz heater 102.

Generally, the etchant used is a three component etchant including IPA (isopropyl alcohol) / KOH (potassium hydroxide) / H₂O, as explained above. The anisotropic etchant stored in the vessel is separated into two portions, that is, an upper IPA-rich portion "a" and a lower KOH-rich portion "b" according to the specific gravity of each portion.

Another anisotropic etching apparatus 200 as shown in Fig. 11 has a hot plate 201, on which an anisotropic etching vessel 101 is positioned. The anisotropic etchant is indirectly heated using the heat generated by the hot plate 201.

The above conventional apparatuses 100 and 200 have the following problems. In the conventional apparatus 100, a quartz tube 102a, which has a test-tube shape and by which the body of the quartz heater 102 is covered, is corroded by the KOH / IPA in the anisotropic etchant, and typically by a few nm per minute. As a result, after the quartz heater 102 is used for a long time, a hole is formed in the quartz tube 102a, and as a result, the anisotropic etchant may be contaminated.

Another problem also occurs. As explained above, the etching temperature at the anisotropic etching is generally 75 to 81°C, and this temperature range is close to the vaporization temperature of IPA (boiling point: 82.4°C). Therefore, if a spark occurs at a contact in the electric wiring of the quartz heater 101, the evaporated IPA may catch fire.

In addition, when such a heater put into the vessel is used, it is difficult to keep a uniform temperature distribution in the liquid in the vessel.

In order to prevent the above-explained corrosion due to KOH / IPA, a TEFLON-coated heater may be used, in which the tube body is covered by a TEFLON material. However, also in this case, it is impossible to prevent the contamination of the etchant caused by pin holes, or to prevent the evaporated IPA component from catching fire due to sparks.

The problem caused by the conventional apparatus 200 will be explained below. The portion directly heated by the hot plate 201 is only the bottom face of the anisotropic etching vessel 101. In this case, there occurs a problem in that the efficiency of heating the anisotropic etchant in the vessel is relatively low.

Additionally, also in this case, if a spark occurs at a contact in the electric wiring of plate 201, the evaporated IPA component may catch fire because the hot plate 201 is positioned immediately below the etching vessel 101. Here, a hot stirrer having a similar function may be used in place of the hot plate 201. However, also in this case, a problem similar to that caused by the hot plate 201 occurs.

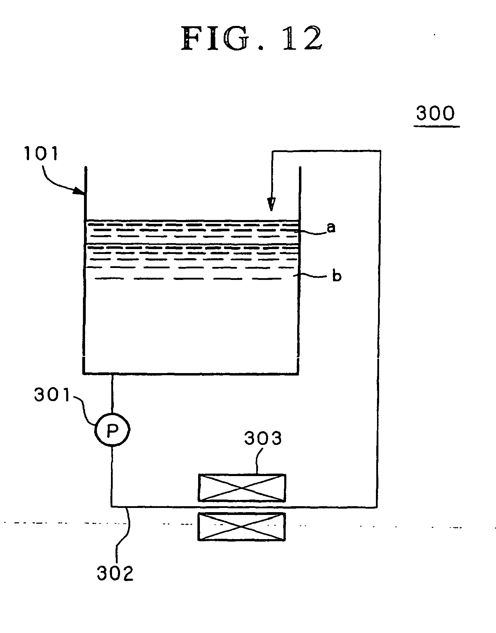

In order to solve such a conventional problem, an anisotropic etching apparatus as shown in Fig. 12 is known.

In the anisotropic etching apparatus 300 in Fig. 12, an etchant circulating passage 302 having a circulating pump 301 is attached to the anisotropic etching vessel 101, and a heater 303 for heating the anisotropic etchant passing through the etchant circulating passage 302 is provided in the middle of the passage 302.

When the circulating pump 301 is operated, the anisotropic etchant in the anisotropic etching vessel 101 is drawn from the bottom of the vessel to the etchant circulating passage 302. The drawn anisotropic etchant is then heated by the heater 303 provided in the middle of the passage, and is returned to the anisotropic etching vessel 101 from the upper side of the vessel through the etchant surface.

In such a conventional apparatus 300 having a function of circulating the anisotropic etchant, a portion of the KOH-rich etchant is drawn from the lower portion (i.e., KOH-rich portion "b") of the two divided upper and lower layers. Therefore, the composition of the anisotropic etchant may not stay in a suitable range.

Even if it is assumed that a portion of the upper layer, that is, the IPA-rich portion "a" is drawn, a similar problem occurs. In addition, if it is assumed that a portion of the IPA-rich portion "a" and a portion of the KOH-rich portion "b" are simultaneously drawn, then another problem may occur in which it is difficult to balance the absorption between the IPA-rich etchant and the KOH-rich etchant.

According to the above-explained change of the etching characteristics caused by the change of the concentration of the anisotropic etchant used in the anisotropic etching, a plurality of mu pyramids P may be generated, and the depth of each etched portion may not be uniform.

Reference is made to JP 05 066714 U, which discloses an apparatus and method for etching a surface of a semiconductor wafer using an etchant comprising a saturated solution of potassium hydroxide (KOH) and isopropyl alcohol (IPA). To maintain the etchant as a saturated solution despite evaporation of IPA, quantities of IPA and KOH are selectively added, based on sensed levels of the upper IPA layer and the lower KOH layer in the etching vessel.

### SUMMARY OF THE INVENTION

According to the present invention, there is provided an anisotropic etching method of immersing a semiconductor wafer in an anisotropic etchant contained in an anisotropic etching vessel having an open area, so as to anisotropically etch a surface of the wafer, comprising the step of: full-time or almost full-time supplying a replenishing etchant component, which compensates for the evaporation of said component from the surface of the anisotropic etchant during the anisotropic etching, by an amount corresponding to the evaporated amount of the component, wherein the replenishing etchant component is supplied along an inner face of a side wall (11a) of the anisotropic etching vessel, so as to flow along the inner face.

An advantage achievable with embodiments of the present invention is to provide an anisotropic etching method for solving the above-explained problems and improving the anisotropic etching.

More specifically, embodiments of the present invention are able to provide an anisotropic etching method for (i) preventing a change of the composition of the anisotropic etchant caused by the vaporization and disappearance of a component of the etchant, (ii) performing stable anisotropic etching of a semiconductor wafer, (iii) reducing the number of µ pyramids generated on the etched surface of the semiconductor wafer, and (iv) reducing the ununiformity of the depth of the etching.

Another advantage attainable with embodiments of the present invention is to provide an anisotropic etching method for (i) preventing the contamination of the anisotropic etchant, (ii) improving the distribution of the etching depth and the anisotropic distribution measured at the surface of the anisotropically etched wafer, and (iii) suppressing the generation of the µ pyramids on the surface of the etched wafer.

During the anisotropic etching, a portion of the anisotropic etchant is always evaporating from the surface of the etchant, due to the heat of the etchant. Here, the anisotropic etchant is controlled to keep a relatively high temperature. In the method according to the present invention, a replenishing etchant component which replenishes a component which evaporates is continuously (full-time or almost full-time) supplied during the anisotropic etching, by an amount corresponding to the amount of the evaporated component, that is, by a relatively small amount. Accordingly, the temperature of the anisotropic etchant is not decreased, and a change in concentration can be prevented, thereby stably performing the anisotropic etching. Therefore, it is possible to prevent generation of a plurality of mu pyramids and ununiformity of the etching depth at the etched surface of the wafer, due to a temperature or concentration change of the anisotropic etchant.

The replenishing of the evaporated component is continuously performed during the anisotropic etching, by relatively a small amount. Therefore, the temperature of the etchant is barely decreased, thereby preventing a change of the composition of the anisotropic etchant. Accordingly, the anisotropic etching of the semiconductor wafer can be stably performed.

Typically, the semiconductor wafer is a silicon wafer.

The kind of the anisotropic etchant is not limited. For example, an alkaline etchant such as KOH (IPA / KOH / H₂O), KOH (hydrazine / KOH / H₂O), or the like may be used. Here, IPA (boiling point: 82.4°C) is a typical example of a component evaporating at an etching temperature of 75 to 81°C.

The shape or size of the anisotropic etching vessel is also not limited. For example, a square or circular vessel may be used. In addition, a roof member may be provided in the open area through which a wafer case containing semiconductor wafers is inserted and removed.

The anisotropic etching vessel can be made of a material generally known for semiconductor-etching use, such as a quartz glass, PYREX glass, polypropylene, PTFE (tetrafluoroethylene resin), PEA (resin of a perfluoroalkyl vinyl ether copolymer), or the like.

The method of continuously (full-time or almost full-time) replenishing the evaporated component from the anisotropic etchant by an amount corresponding to the amount of the evaporated component is also not limited.

For example, the amount of the evaporated component (evaporating from the surface of the anisotropic etchant) per unit time is determined in advance, and a replenishing etchant corresponding to the detected amount is continuously (full-time or almost full-time) supplied.

On the other hand, a variation in the surface level of the etchant may be detected using any kind of level sensor, or a variation in the weight of the anisotropic etching vessel containing the anisotropic etchant may be detected using any kind of load cell, and then a replenishing etchant component corresponding to the evaporated component is continuously (full-time or almost full-time) supplied.

Preferably, the amount of the replenishing etchant component is as small as possible, and the replenishing etchant component is supplied as smoothly as possible. This is because it is preferable that the change of temperature or concentration of the anisotropic etchant be as small as possible, so as to further reduce the number of µ pyramids generated on the etched surface of the wafer, and to obtain a much more uniform etching depth. The µ pyramids are generated due to a change in the temperature or concentration of the anisotropic etchant.

In the above method, the replenishing etchant component is supplied along an inner face of a side wall of the anisotropic etching vessel, so as to flow along the inner face. The method of supplying the replenishing etchant component along an inner face of a side wall of the anisotropic etching vessel is not limited. For example, a replenishing nozzle for supplying a liquid, which compensates for the evaporated component, along an inner face of a side wall of the anisotropic etching vessel may be used. In this case, the etchant surface is disturbed very little (i.e., it remains very smooth); thus, the number of generated µ pyramids can be further reduced.

### BRIEF DESCRIPTION OF THE DRAWINGS

To enable a better understanding of the present invention, and to show how the same may be carried into effect, reference will now be made, by way of example only, to the accompanying drawings, in which:-
Fig. 1 is a perspective view showing an exemplary anisotropic etching apparatus for carrying out the method according to the present invention;
Fig. 2 is a diagram showing measured portions on the surface of a silicon wafer;
Fig. 3 is a diagram showing an anisotropic etching pattern;
Fig. 4 is a diagram for explaining a second exemplary anisotropic etching apparatus which is not part of the present invention as claimed;
Fig. 5. is a diagram for explaining a third exemplary anisotropic etching apparatus, which again is not part of the present invention as claimed;
Fig. 6 is a diagram for explaining a conventional process of replenishing the vessel with IPA;
Fig. 7 is a graph showing the relationship between the replenishment timing and variations in the etching state;
Fig. 8 is a partially-enlarged sectional view of a surface of an anisotropically etched semiconductor wafer;
Fig. 9 is a partially-enlarged plan of a surface of an anisotropically etched semiconductor wafer;
Fig. 10 is a diagram for explaining a conventional anisotropic etching apparatus;
Fig. 11 is a diagram for explaining another conventional anisotropic etching apparatus; and
Fig. 12 is a diagram for explaining another conventional anisotropic etching apparatus.

### DETAILED DESCRIPTION

An anisotropic etching apparatus is disclosed, which comprises an anisotropic etching vessel having an open area and containing an anisotropic etchant for anisotropically etching a semiconductor wafer; an evaporated component compensating device for continuously supplying a replenishing etchant component which compensates for the evaporation of a component from the surface of the anisotropic etchant during the anisotropic etching, by an amount corresponding to the evaporated amount of the component.

Typically, the evaporated component compensating device comprises: a flow meter for measuring an amount of the supplied replenishing etchant component; a regulator for controlling the amount of the replenishing etchant component according to the measured value of the flow meter; and a needle valve provided in the middle of a pipe through which the replenishing etchant component is supplied.

That is, the amount of the supplied replenishing etchant component is measured by the flow meter, and the amount of the replenishing etchant component is controlled by the regulator according to the measured value of the flow meter. More specifically, the opening degree of the needle valve (provided in the middle of the pipe through which the replenishing etchant is supplied) is controlled. Accordingly, a very small amount of the replenishing etchant component can be supplied so as to compensate for the evaporated component.

The kind of the flow meter is not limited, and any type for measuring the supplied amount of the replenishing etchant component may be used. For example, an orifice flow meter, digital flow meter, purge flow meter, or the like, may be used. The kind of the regulator is also not limited, and any type for controlling the supplied amount of the replenishing etchant component may be used. In addition, the kind of needle valve is also not limited, and any type for finely controlling the supply of the replenishing etchant component may be used.

That is, the evaporated component compensating device has a function of supplying and controlling a very small amount of liquid per unit time, for example, a roller pump may be used.

In addition, the evaporated component compensating device may comprise a replenishing nozzle for supplying the replenishing etchant component along an inner face of a side wall of the anisotropic etching vessel, so as to make the etchant component flow along the inner face. That is, when the evaporated component is compensated, the replenishing etchant component is made to flow along an inner face of a side wall of the anisotropic etching vessel, by using the replenishing nozzle. The number of nozzles is not limited, that is, one or more nozzles can be used. Within a possible attachment angle range of the nozzle of 0 to 90 degrees, 5 to 60 degrees are preferable.

The top end of the replenishing nozzle is made to contact a side plate (or wall) of the anisotropic etching vessel, or is placed in the vicinity of a side plate of the vessel. In another arrangement example, the nozzle is joined with the vessel by coupling the nozzle to a through hole provided in a side plate of the vessel. Accordingly, the replenishing liquid discharged from the top end of the nozzle reaches to the surface of the anisotropic etchant along an inner face of a side wall of the vessel; thus, the etchant surface is not readily disturbed and the number of generated µ pyramids can be further educed.

Moreover, an anisotropic etching apparatus is disclosed, not forming part of the invention as claimed, which comprises: an anisotropic etching vessel having an open area and containing an anisotropic etchant for anisotropically etching a semiconductor wafer; a heating medium jacket, provided at the outside of the anisotropic etching vessel, for containing a heating medium for indirectly heating the anisotropic etchant in the vessel; a heating medium circulating passage, both ends of which are respectively joined with the heating medium jacket, for drawing and guiding the heating medium from the anisotropic etching vessel to a position separated from the vessel by a predetermined distance, and then returning the drawn heating medium to the heating medium jacket; a circulating pump, provided in the middle of the heating medium circulating passage, for circulating the heating medium; and a heating device, provided in the middle of the heating medium circulating passage and away from the anisotropic etching vessel, for heating the heating medium flowing through the heating medium circulating passage, and wherein the above predetermined distance is determined so as to satisfy the condition that even if a spark is generated in the heating device, an evaporated component of the anisotropic etchant around the anisotropic etching vessel will not catch fire.

In this structure, when the circulating pump is operated, the heating medium in the heating medium jacket is drawn from the jacket to the heating medium circulating passage. The drawn heating medium is then heated by the heating device provided in the middle of the heating medium circulating passage, and then returned to the heating medium jacket. The anisotropic etchant contained in the anisotropic etching vessel is heated by using the heat of the returned heating medium.

That is, the heating medium for indirectly heating the anisotropic etchant is once drawn to the outside of the heating medium jacket, and is heated and then returned to the jacket. Therefore, the anisotropic etchant is not contaminated when the etchant is heated (it may be contaminated by a conventional heater put into the vessel), and it is possible to prevent the evaporated volatile component of the anisotropic etchant from catching fire due to a spark generated in the heating device. In addition, it is easy to keep the etchant at a fixed temperature.

In the conventional method, the anisotropic etchant itself is circulated. Therefore, the composition of the anisotropic etchant is not stable during the anisotropic etching; thus, stable etching characteristics cannot be obtained. In contrast, in the disclosed apparatus, a heating medium for heating the anisotropic etchant is circulated, as explained above; thus, the composition of the anisotropic etchant does not change, thereby suppressing the generation of the µ pyramids and stabilizing the etching characteristics such as the etching depth, etching speed, and the like, and the characteristics related to the etchant.

As in the above-explained method and apparatus, a silicon wafer is a typical example of the semiconductor wafer. The kind of the anisotropic etchant, and the shape and size of the anisotropic etching vessel are not limited, and any material generally used for semiconductor etching use may be used as a material of the vessel (refer to the above relevant explanation)

The heating medium for heating the anisotropic etchant may be water (e.g., hot and pure water) or oil. Hot and pure water is preferable because even if the anisotropic etching vessel is damaged and the heating medium is introduced into the vessel, the damage caused by the heating medium is relatively small.

The position of the heating medium jacket provided outside the anisotropic etching vessel is not limited. For example, the heating medium jacket may surround all or a part of the outer faces of the walls of the anisotropic etching vessel. The size, shape, and material of the heating medium jacket are not limited.

The length of the heating medium circulating passage is not limited, and is determined so as to satisfy the condition that the heating medium can be drawn from the anisotropic etching vessel to a predetermined distance, and then returned to the heating medium jacket. The material of the heating medium circulating passage is also not limited, but it is necessary to select a material which does not corrode due to the passing heating medium, and which does not melt due to the heat generated by the heating device. A metallic pipe such as a stainless or aluminium pipe, a synthetic resin pipe having heat resistance, or the like may be used

The above predetermined distance is determined so as to satisfy the condition that even if a spark is generated in the heating device for any reason, an evaporated volatile component of the anisotropic etchant around the anisotropic etching vessel will not catch fire. This condition is provided for separating the atmosphere around the anisotropic etching vessel from the atmosphere around the heating device.

Any kind of pump which can pump the heating medium may be used as the circulating pump.

The kind of the heating device is also not limited, and any device which can increase the temperature of the medium passing through the heating medium circulating passage up to a predetermined level may be used, for example, an electric heater, any kind of heat exchanger may be used.

In the above structure, the heating medium jacket may have a shape for surrounding sides of the anisotropic etching vessel, and the anisotropic etching apparatus may further comprise an agitating device, provided at the bottom side of the anisotropic etching vessel, for indirectly agitating the anisotropic etchant in the vessel. In this case, the anisotropic etchant in the anisotropic etching vessel is agitated by the agitating device while the anisotropic etchant is heated by the heating device. Therefore, the anisotropic etchant in the anisotropic etching vessel can be uniformly heated.

An ultrasonic vibrator or magnetic stirrer may be used as the agitating device, however, the agitating device is not limited to these examples. The agitation using the above agitating device is performed in a manner such that the anisotropic etchant is shaken as gently as possible. If the etchant is roughly shaken, differences in concentration occur in the anisotropic etchant, so that the distribution of the etching depth of the semiconductor wafer is made ununiform.

The heating medium jacket may have a shape for surrounding sides and a bottom face of the anisotropic etching vessel. In this case, the efficiency of heating the anisotropic etchant by using the heating medium can be improved.

As a typical example, the anisotropic etchant includes an upper IPA-rich portion and a lower KOH-rich portion which are separated according to the specific gravity of each portion; and the heating medium jacket has a shape for surrounding a target portion of sides of the anisotropic etching vessel, the target portion corresponding only to the KOH-rich portion. In this case, only the lower KOH-rich portion is heated by the heating medium in the heating medium jacket. Therefore, the increase of the temperature of the IPA-rich liquid (i.e., the IPA-rich portion), which has relatively high volatility, is relatively small; thus, the IPA portion is not much significantly vaporized by the above heating operation. As a result, the amount of an evaporated component of IPA from the surface of the anisotropic etchant can be reduced.

Examples of the apparatuses described above, not forming part of the invention as claimed, can provide an anisotropic etching apparatus for uniformly eating the anisotropic etchant contained in an anisotropic etching vessel.

Other examples of these apparatuses, not forming part of the invention as claimed, can to provide an anisotropic etching apparatus for improving the efficiency of heating the anisotropic etchant using a heating medium.

Other examples of these apparatuses not forming part of the invention as claimed, can provide an anisotropic etching apparatus for reducing the quantity of the volatile component evaporated from the anisotropic etchant.

Hereinbelow, illustrated examples of such anisotropic etching apparatuses will be explained.

### First example

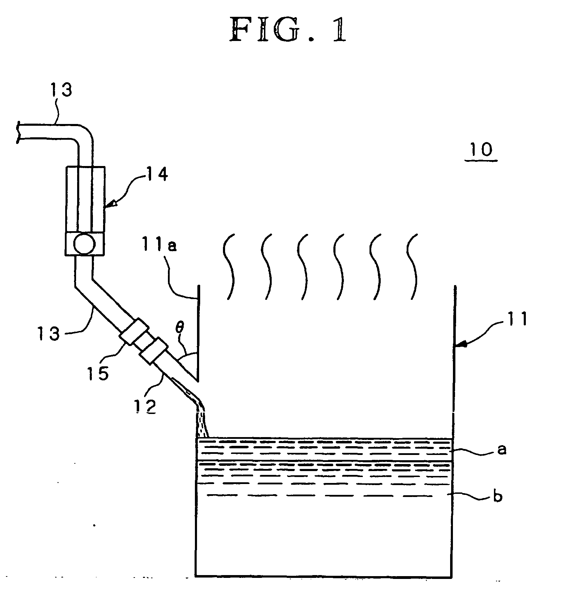

Fig. 1 is a perspective view showing the first exemplary anisotropic etching apparatus.

In Fig. 1, reference numeral 10 indicates the anisotropic etching apparatus. This anisotropic etching apparatus 10 comprises an anisotropic etching vessel 11 and an evaporated component compensating unit 14 (i.e., evaporated component compensating device) which is attached to a center area of a side plate 11a of the vessel 11 via a replenishing nozzle 12 and a replenishing pipe 13.

The anisotropic etching vessel 11 is made of a quartz glass and has a cubical shape, and has chemical resistance to a three component anisotropic etchant of IPA /KOH /H₂O. The volume of the vessel is 20 L, and the top of the vessel is open, that is, the vessel has an open top area.

A wafer case containing a plurality of silicon wafers (not shown) is immersed in the anisotropic etchant through the open area. The anisotropic etchant is separated into an upper IPA-rich portion "a" and a lower KOH-rich portion "b" according to the specific gravity of each portion. The replenishing nozzle 12 is attached to the outside face of a side plate 11a of the vessel at an angle θ. This attachment angle θ is 45 degrees in this embodiment.

An end of the replenishing pipe 13' is joined with an end of the replenishing nozzle 12 via a joint 15. The other end of the replenishing pipe 13 is connected to an IPA supply vessel (not shown).

In addition, the evaporated component compensating unit 14 is attached to an end portion (at the etching vessel side) of the replenishing pipe 13. A flow meter, regulator, and needle valve (not shown) are provided in the casing of the evaporated component compensating unit 14. The flow rate of a replenishing etchant is measured using the flow meter, and according to the measured value, the opening degree of the needle valve is controlled by using the regulator. Accordingly, the supplied amount of the replenishing etchant is controlled.

Below, the processes of anisotropically etching a silicon wafer by using the anisotropic etching apparatus 10 will be explained.

First, a wafer case containing silicon wafers is immersed in an anisotropic etchant in the anisotropic etching vessel 11. The anisotropic etching is then performed while the temperature of the etchant is kept within a predetermined range. Here, the etching progress in the depth direction is faster than the etching progress in the horizontal direction according to the direction of the crystal plane of the silicon wafer. Therefore, an anisotropic etching groove w1 having a V-shaped section as shown in the above Figs. 8 and 9 is formed.

In the above process, the heating temperature of the anisotropic etching is 75 to 81 °C. Within this temperature range, the IPA portion, which has the highest volatility in the etchant, is vaporized. That is, a large amount of IPA vapor is generated from the top surface of the upper IPA-rich portion "a". This IPA vapor then escapes to the outside of the vessel from the open top area. As a result, the amount of IPA of the IPA-rich portion "a" is reduced.

In the present embodiment, during the anisotropic etching, replenishing liquid IPA is supplied via the replenishing nozzle 12 from the evaporated component compensating unit 14. This replenishment process is continuously performed during the etching, and the replenishment amount at each time is relatively small.

Here, the replenishing nozzle 12 is joined to the side plate 11a at the attachment angle θ. Therefore, the replenishing liquid from the evaporated component compensating unit 14 can smoothly reach the top surface of the etchant, along the inner wall of the side plate 11a. As a result, the surface of the anisotropic etchant does not tend to be disturbed and the generation of µ pyramids caused by disturbing the surface of the etchant can be suppressed.

Additionally, the compensation of the evaporated component is continuously and gradually performed by using the evaporated component compensating unit 14 during the anisotropic etching. In this case, the temperature of the etchant is not substantially reduced. The concentration is also not substantially changed. Therefore, it is possible to prevent the composition of the anisotropic etchant from changing. Such a composition change cannot be prevented when a conventional measuring cylinder is used. As a result, anisotropic etching can be stably performed.

The conventional IPA compensating method using a measuring cylinder and the IPA compensating method using the evaporated component compensating device according to the present invention were comparatively tested under the following conditions of anisotropic etching. Below, the number of generated µ pyramids and the depth of etching will be shown for both methods.

The conditions of the anisotropic etching were (i) to use a silicon wafer which has a diameter of 5 inches (12.7 cm) and has a pattern formed on an oxide film on a surface of the wafer, (ii) to use an etchant having a composition of IPA : KOH : H₂O = 5 : 2 : 70 (mass ratio), (iii) to employ an etching temperature of 80 °C, and (iv) to employ an etching time of 60 minutes. In the conventional method, the compensation of IPA of the anisotropic etching was performed in a manner such that the operator replenished the vessel by an amount corresponding to the loss of the volatile component of the anisotropic etchant at regular intervals of 10 minutes by using a measuring cylinder. In contrast, in the method of the present invention, a replenishing amount of 43 ml /min corresponding to the amount of the evaporated component of IPA was continuously compensated.

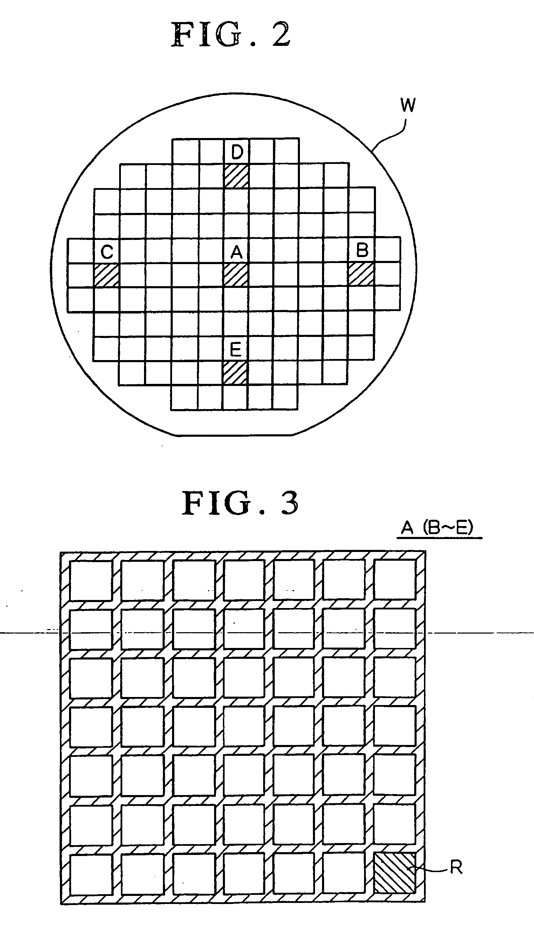

There were 25 wafers per wafer case. A wafer case was batch-processed in a single anisotropic etching operation. In addition, as shown in Fig. 2 which explains the measured portions on the surface of the silicon wafer, 5 target portions to be measured were provided, that is, center portion A and peripheral portions B to E were provided, where portions B to E were separated by 90 degrees from each other. The diagram of Fig. 3 shows an anisotropic etching pattern for each portion A to E, where the pattern area of the anisotropic etching corresponds to a shaded area which includes 49 small square areas. The number of generation of the µ pyramids and the depth of the etching were measured in the pattern area. The size of each of portions A to E was 8600 µm × 8600 µm in which 49 small patterns (the size of each small pattern is 1100 µm × 1100 µm) were formed. The width of each groove of the anisotropic etching was 100 µm. However, the width of the outer peripheral groove which surrounds the portion including the small patterns was 150 µm.

The number of the µ pyramids was measured using a microscope. That is, in each target portion A to E on a silicon wafer, the number of the µ pyramids generated in the bottom of the anisotropically etched area (i.e., the shaded area in Fig. 3) was counted. This counting process was performed for each of the 25 wafers. A similar anisotropic etching test operation was performed for another set of 25 wafers, that is, the test was repeated two times. The results of the test are shown in Table 1. The average and standard deviation of the two test operations are also shown in Table 1.

**Table 1**

| Counted number of generated µ pyramids | | | | |
|---|---|---|---|---|
| Wafer No. | Conventional method | | Present-invention method | |
| | 1st operation | 2nd operation | 1st operation | 2nd operation |
| 1 | 3 | 0 | 0 | 0 |
| 2 | 2 | 2 | 0 | 0 |
| 3 | 2 | 0 | 0 | 0 |
| 4 | 1 | 3 | 0 | 0 |
| 5 | 5 | 3 | 1 | 0 |
| 6 | 0 | 2 | 0 | 0 |
| 7 | 3 | 3 | 0 | 0 |
| 8 | 3 | 0 | 2 | 0 |
| 9 | 3 | 2 | 0 | 0 |
| 10 | 0 | 1 | 0 | 0 |
| 11 | 2 | 4 | 0 | 1 |
| 12 | 1 | 4 | 0 | 0 |
| 13 | 3 | 1 | 0 | 0 |
| 14 | 2 | 0 | 0 | 0 |
| 15 | 4 | 1 | 0 | 1 |
| 16 | 4 | 2 | 1 | 0 |
| 17 | 3 | 2 | 0 | 0 |
| 18 | 0 | 3 | 0 | 0 |
| 19 | 2 | 0 | 0 | 0 |
| 20 | 1 | 2 | 0 | 0 |
| 21 | 5 | 1 | 0 | 1 |
| 22 | 3 | 2 | 0 | 0 |
| 23 | 3 | 0 | 0 | 1 |
| 24 | 0 | 2 | 0 | 0 |
| 25 | 3 | 2 | 1 | 0 |
| Average | 2.3 | 1.7 | 0.2 | 0.2 |
| Standard deviation | 1.5 | 1.2 | 0.5 | 0.4 |

Next, the depth of etching was measured using an optical step measuring device. More specifically, in each of the above portions A to E shown in Fig. 2, the depth was measured at a point in the groove surrounding the rightmost small pattern in the lowest line (i.e., shaded small pattern R in Fig. 3), and the average of the 5 measured results of A to E was calculated. This process was performed for each of 25 wafers. This test operation was then repeated for another set of 25 wafers, that is, the above test operation was performed two times. The results are shown in Table 2. The average and standard deviation of the two test operations are also shown in Table 2.

**Table 2**

| Etching depth | | | | |
|---|---|---|---|---|
| Wafer No. | Conventional method | | Present-invention method | |
| | 1st operation | 2nd operation | 1st operation | 2nd operation |
| 1 | 61 | 63 | 62 | 61 |
| 2 | 63 | 66 | 62 | 63 |
| 3 | 68 | 67 | 61 | 63 |
| 4 | 67 | 64 | 63 | 62 |
| 5 | 65 | 64 | 62 | 60 |
| 6 | 62 | 65 | 61 | 60 |
| 7 | 59 | 62 | 60 | 61 |
| 8 | 54 | 59 | 62 | 62 |
| 9 | 53 | 58 | 63 | 61 |
| 10 | 56 | 56 | 61 | 62 |
| 11 | 57 | 57 | 62 | 61 |
| 12 | 58 | 54 | 63 | 62 |
| 13 | 55 | 58 | 62 | 62 |
| 14 | 57 | 62 | 61 | 61 |
| 15 | 56 | 60 | 63 | 63 |
| 16 | 54 | 61 | 62 | 63 |
| 17 | 64 | 59 | 63 | 62 |
| 18 | 63 | 68 | 61 | 61 |
| 19 | 66 | 64 | 60 | 63 |
| 20 | 65 | 65 | 63 | 63 |
| 21 | 60 | 63 | 62 | 62 |
| 22 | 61 | 61 | 61 | 61 |
| 23 | 63 | 65 | 63 | 60 |
| 24 | 62 | 64 | 62 | 62 |
| 25 | 59 | 60 | 62 | 61 |
| Average | 60.3 | 61.8 | 61.9 | 61.7 |
| Standard deviation | 4.3 | 3.6 | 0.9 | 1.0 |

As shown in the above tables, in the method according to the present invention, the number of generated µ pyramids was smaller and the etching or etched depth was much more uniform over the whole measured pattern area of the wafer, in comparison with the conventional method. Therefore, in the present invention, the anisotropic etching could be stably performed for all the wafers contained in the wafer case.

### Second example

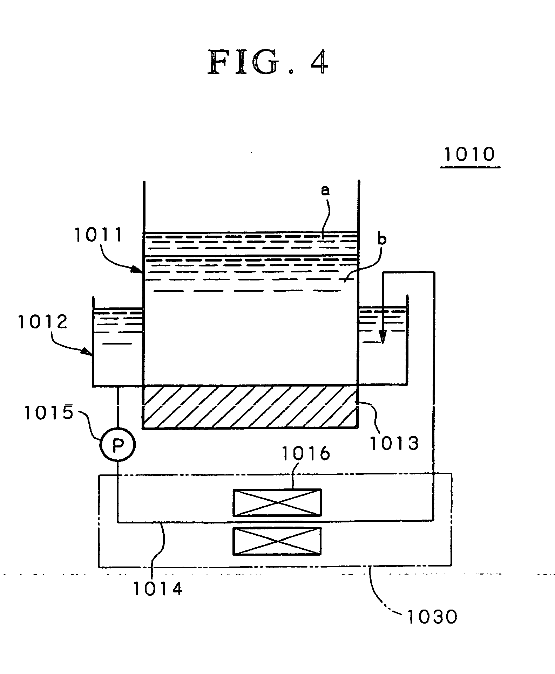

Fig. 4 is a diagram for explaining the anisotropic etching apparatus of a second disclosed example not forming part of the claimed invention.

In Fig. 4, reference numeral 1010 indicates the anisotropic etching apparatus of the second example. This anisotropic etching apparatus 1010 comprises (i) a circular anisotropic etching vessel 1011, (ii) a heating medium jacket 1012 which surrounds the outer peripheral face of the vessel 1011 and contains hot and pure water (i.e., a heating medium) for indirectly heating the anisotropic etchant in the vessel, (iii) an ultrasonic vibrator 1013 (functioning as an agitating device), attached to the bottom of the anisotropic etching vessel 1011, for indirectly agitating the anisotropic etchant in the vessel, (iv) a beating medium circulating passage 1014, both ends of which are respectively joined with the heating medium jacket 1012, for drawing and guiding the hot and pure water from the anisotropic etching vessel 1011 to a position away from the vessel, and then returning the drawn water to the heating medium jacket 1012, (v) a hot and pure water circulating pump 1015 provided in the middle of the heating medium circulating passage 1014, and an electric heater (i.e., a heating device) 1016, provided in the middle of the beating medium circulating passage 1014 (that is, the heater 1016 is away from the anisotropic etching vessel 1011), for heating the hot and pure water flowing through the heating medium circulating passage 1014.

The anisotropic etching vessel 1011 is made of a quartz glass and has chemical resistance to a three component anisotropic etchant of IPA /KOH /H₂O. The volume of the vessel is 20 L.

A wafer case including a plurality of silicon wafers W (not shown) is put in the anisotropic etchant through the open top area of the vessel. The anisotropic etchant is separated into an upper IPA-rich portion "a" and a lower KOH-rich portion "b" according to the specific gravity of each portion.

The above heating medium jacket 1012 is a vessel made of quartz and has a doughnut shape in a plan view. This jacket surrounds only a part of the side wall of the vessel 1011, that is, the surrounded part corresponding to the KOH-rich portion "b". The top of the heating medium jacket 1012 is also open, and an end of the heating medium circulating passage 1014 is connected to the bottom of the heating medium jacket 1012. The other end of the heating medium circulating passage 1014 is inserted into the heating medium jacket 1012 from the upper open area of the jacket. The heating medium circulating passage 1014 has a tube body which is made of PFA (resin of a perfluoroalkyl vinyl ether copolymer) and the total length of the tube is 3 m.

The above circulating pump 1015 is provided for pumping the hot and pure water at a speed of 15 L/min, and the pump and is attached at a position close to an end of the heating medium jacket 1012.

The above electric heater 1016 is provided in the middle of the heating medium circulating passage 1014, and the position of the heater 1016 is 1 meter away from the anisotropic etching vessel 1011. The atmosphere around the electric heater 1016 is separated from that of the anisotropic etching vessel 1011 by using a partition wall 1030.

Below, the processes of anisotropically etching silicon wafers W by using the anisotropic etching apparatus 1010 will be explained.

First, a wafer case containing a plurality of silicon wafers (not shown) is immersed in the anisotropic etchant in the anisotropic etching vessel 1011. The temperature of this etchant is kept within a range of 75 to 81 °C, and the anisotropic etching is performed in a manner such that the etching speed in the depth direction is higher than that of the horizontal direction due to the direction of the crystal plane of the silicon wafer. Accordingly, anisotropic etching groove w1 having a V-shaped section as shown in Figs. 8 and 9 is formed.

In the above process, it is necessary to keep the heating temperature of the anisotropic etchant within the range of 75 to 81°C. Therefore, the hot and pure water is continuously heated and circulated during the anisotropic etching. More specifically, the circulating pump 1015 is operated so as to draw the hot and pure water from the heating medium jacket 1012 towards the heating medium circulating passage 1014. This drawn hot and pure water is heated by the electric heater 1016 provided in the middle of the circulating passage, and is then returned to the heating medium jacket 1012. The heat of the returned hot and pure water (at approximately 85°C) heats the lower portion (i.e., KOH-rich portion "b") in the anisotropic etching vessel 1011. The temperature of the etchant can be stabilized as explained above.

In the second example, even if the electric heater 1016 is damaged, the anisotropic etchant is not contaminated. Additionally, the electric heater 1016 is separated from the anisotropic etching vessel 1011 by 1 meter, and the atmosphere around the heater is isolated by using the partition wall 1030. Therefore, even if a spark is generated at an electric contact in the electric heater 1016, the evaporated volatile component of the anisotropic etchant around the anisotropic etching vessel 1011 will not catch fire due to the spark.

In addition, the hot and pure water for indirectly heating the anisotropic etchant is completely separated from the contents of the anisotropic etching vessel 1011, and is circulated between the heating medium jacket 1012 and the heating medium circulating passage 1014. Accordingly, the composition change of the etchant, as observed in the conventional apparatus 300 of Fig. 12, does not occur in the present embodiment. As a result, the etching depth and the anisotropic etching characteristics can be uniform over the etched surface of the wafer, and the generation of µ pyramids can be suppressed.

Also in the second example, the anisotropic etchant is delicately agitated using the ultrasonic vibrator 1013 while the anisotropic etchant in the anisotropic etching vessel 1011 is indirectly heated using the hot and pure water, so that the anisotropic etchant in the anisotropic etching vessel 1011 can be uniformly heated.

In addition, only the lower KOH-rich portion "b" is heated by using the hot and pure water in the heating medium jacket 1012; thus, the increase of the temperature of the IPA-rich portion "a" having a higher volatility is small Accordingly, the vaporization of IPA occurs to a lesser extent, and thus the evaporation of the volatile component of IPA from the surface of the anisotropic etchant can be relatively small.

### Third example

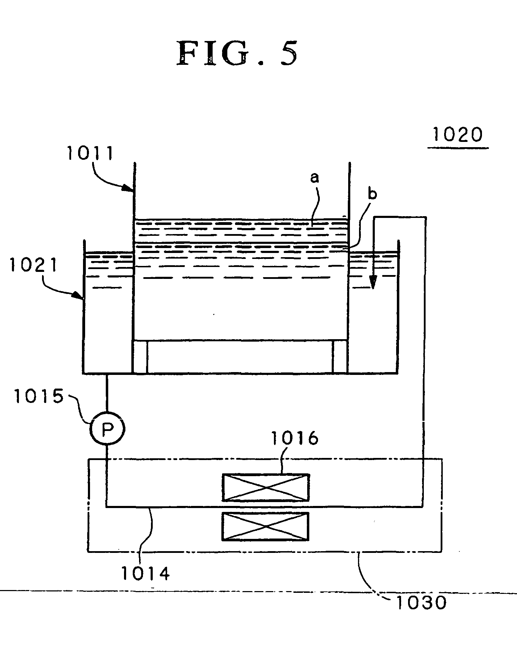

The anisotropic etching apparatus of a third example not forming part of the claimed invention will be explained with reference to Fig. 5. Fig. 5 is a diagram for explaining the structure of the anisotropic etching apparatus of the third example.

In Fig. 5, reference numeral 1020 indicates the anisotropic etching apparatus of the third embodiment. In the apparatus 1020, the ultrasonic vibrator 1013 used in the second embodiment is omitted, and in place of the heating medium jacket 1012, another type of heating medium jacket 1012 is provided, which surrounds the peripheral side face and bottom of the anisotropic etching vessel 1011.

The third example employs the heating medium jacket 1012 having the above shape; thus, the efficiency of heating the anisotropic etchant by using the hot and pure water can be improved.

The structure, function, and effect related to each of the other elements are the same as those of the second example, and explanations thereof are omitted here.

## Claims

1. An anisotropic etching method of immersing a semiconductor wafer in an anisotropic etchant contained in an anisotropic etching vessel (11) having an open area, so as to anisotropically etch a surface of the wafer, comprising the step of:
full-time or almost full-time supplying a replenishing etchant component, which compensates for the evaporation of said component from the surface of the anisotropic etchant during the anisotropic etching, by an amount corresponding to the evaporated amount of the component, wherein the replenishing etchant component is supplied along an inner face of a side wall (lla) of the anisotropic etching vessel (11), so as to flow along the inner face.

## Patentansprüche

1. Anisotropisches Ätzverfahren zum Eintauchen eines Halbleiter-Wafers in ein anisotropischen Ätzmittel, das in einem ein offenes Gebiet aufweisenden Behälter für anisotropisches Ätzen (11) aufgenommen ist, um eine Fläche des Wafers anisotropisch zu ätzen, umfassend den Schritt:
Ständiges oder fast ständiges Zuführen einer Nachfüll-Ätzmittelkomponente, die das Verdampfen der Komponente von der Oberfläche des anisotropischen Ätzmittels während des anisotropischen Ätzens um eine der verdampften Menge der Komponente entsprechende Menge kompensiert, wobei die Nachfüll-Ätzmittelkomponente so entlang einer Innenfläche einer Seitenwand (lla) des Behälters für anisotropisches Ätzen (11) zugeführt wird, dass sie entlang der Innenfläche strömt.

## Revendications

1. Procédé de gravure anisotrope d'immersion d'une plaquette de semi-conducteur dans un agent de gravure anisotrope contenu dans un récipient de gravure anisotrope (11) ayant un espace ouvert, de sorte à graver de manière anisotrope une surface de la plaquette, comprenant l'étape de :
alimentation à temps plein ou presque à temps plein d'un composant d'agent de gravure reconstituant, ce qui compense l'évaporation dudit composant de la surface de l'agent de gravure anisotrope pendant la gravure anisotrope, par une quantité correspondant à la quantité évaporée du composant, dans laquelle le composant d'agent de gravure reconstituant est alimenté le long d'une face interne d'une paroi latérale (11a) du récipient de gravure anisotrope (11), de sorte à couler le long de la face interne.
